# EUROPÄISCHE PATENTSCHRIFT

(11) **EP 1 499 002 B1**
(45) Veröffentlichungstag und Bekanntmachung des Hinweises auf die Patenterteilung: **12.03.2008**
(21) Anmeldenummer: 04016662.1
(22) Anmeldetag: 15.07.2004
(51) Int. Cl.: H02K 11/00, H02K 29/10

(54) **Encoder-Elektromotor-Baueinheit und Verfahren zur Montage der Baueinheit**
Unit comprising an encoder and an electric motor and method of assembly of such a unit
Unité comprenant un codeur et un moteur électrique et procédé de montage d'une telle unité

(30) Priorität: 15.07.2003 DE 10332167
(43) Veröffentlichungstag der Anmeldung: 19.01.2005
(73) Patentinhaber: PWB-Ruhlatec Industrieprodukte GmbH, 99846 Seebach (DE)
(72) Erfinder: Tenca, Vittorio, 37013 Caprino Veronese (VR) (IT); Carradori, Corrado, 37026 Pescantina (VR) (IT)
(74) Vertreter: Müller-Wolff, Thomas

(56) Entgegenhaltungen:
- PATENT ABSTRACTS OF JAPAN Bd. 2003, Nr. 04, 2. April 2003 (2003-04-02) -& JP 2002 359950 A (JIDOSHA DENKI KOGYO CO LTD), 13. Dezember 2002 (2002-12-13)
- PATENT ABSTRACTS OF JAPAN Bd. 2002, Nr. 08, 5. August 2002 (2002-08-05) -& JP 2002 112516 A (MITSUBISHI ELECTRIC CORP), 12. April 2002 (2002-04-12)
- PATENT ABSTRACTS OF JAPAN Bd. 2000, Nr. 15, 6. April 2001 (2001-04-06) & JP 2000 350415 A (MEIDENSHA CORP), 15. Dezember 2000 (2000-12-15)
- PATENT ABSTRACTS OF JAPAN Bd. 2003, Nr. 04, 2. April 2003 (2003-04-02) & JP 2002 357457 A (CANON PRECISION INC; CANON INC), 13. Dezember 2002 (2002-12-13)
- PATENT ABSTRACTS OF JAPAN Bd. 2002, Nr. 08, 5. August 2002 (2002-08-05) & JP 2002 107649 A (RICOH CO LTD), 10. April 2002 (2002-04-10)

## Beschreibung

Die Erfindung betrifft eine Encoder-Elektromotor-Baueinheit. Die Erfindung betrifft ferner ein Verfahren zur Montage einer entsprechend ausgebildeten Encoder-Elektromotor-Baueinheit.

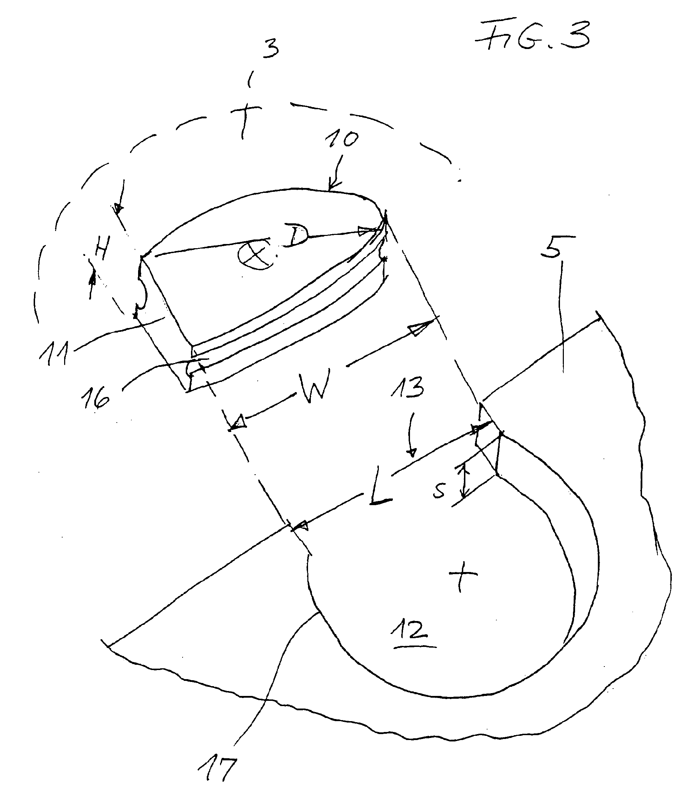

In Patent Abstracts of Japan Bd. 2003 Nr. 4, 2. April 2003 und JP2002359950A ist eine Encoder-Elektromotor-Baueinheit der eingangs genannten Art dargestellt. Gemäß den Figuren 3, 4, 5 und 6 der JP-Veröffentlichung kann ein Sensor, der auf einem Sensorhalter befestigt ist, einfach am Motor justiert werden, indem der Halter um eine Achse geschwenkt wird, die parallel zur Motorwelle verläuft.

An Encoder-Elektromotoren-Baueinheiten werden jedoch hohe Anforderungen hinsichtlich der Mess- und Justiergenauigkeit unter den verschiedensten Umgebungsbedingungen gestellt. Da es sich um Großserienteile handelt, werden fertigungsgerechte Konstruktionen verlangt, die mit möglichst einfachen, störungsunanfälligen und möglichst wenigen Bauteilen auskommen. Die Justierung soll dabei unter allen Umgebungsbedingungen präzisionsgenau selbst unter erschwerten Einbaubedingungen vorgenommen werden können.

Wegen der beengten Einbauverhältnisse werden heute überwiegend Encodersysteme mit U-förmig ausgebildeter Sensor-Emitter-Einheit verwendet. Diese lassen sich zusammen mit den übrigen Bauelementen leicht zu einer Baugruppe zusammenfassen, wobei die Sensor-Emitter-Einheit mit den fertigen Anschlüssen in eine Leiterplatte eingesteckt und mit Kontaktanschlüssen für die Energieversorgung etc. verbunden wird.

Bei einer automatischen Montage besteht unter den gegebenen Voraussetzungen das Problem, Vorschubbewegungen in mehreren Achsen durchführen zu müssen, wobei wegen der hohen Präzisionsgenauigkeit besondere Anforderungen an Montagevorrichtungen, Zustellbewegungen und Führungen der Maschinenelemente zu stellen sind. Dies macht die Encodersysteme teuer und die bekannten Herstellungsverfahren störanfälliq.

Aufgabe der vorliegenden Erfindung ist es daher, eine Encoder-Elektromotor-Baueinheit und ein Verfahren zur Montage derartiger Baueinheiten zu entwickeln, bei denen eine Zentrierung der Taktscheibe auf der Motorwelle und eine Positionierung der Sensor-Emitter-Einheit in einem Arbeitsgang, sowie eine Steuerung der Werkzeuge und Montagevorrichtungen im möglichst einfacher Weise und daher mit hoher Präzisionsgenauigkeit erfolgen kann.

Diese Aufgabe wird erfindungsgemäß durch die in den Patentansprüchen 1 und 8 angegebenen Merkmale gelöst. Es hat sich gezeigt, dass durch die erfindungsgemäße Ausgestaltung der neuen Encoder-Elektromotor-Baueinheit eine einfache Zentrierung der Taktscheibe und der Leiterplatte mit nur zwei Vorschubbewegungen ermöglicht wird. Diese Bewegungen können unabhängig von einander durchgeführt werden, sodass keine Zwischenpositionen eingenommen werden müssen. Die Montage kann mit weitgehend vormontierten Bauelementen in einem Arbeitsgang erfolgen, so dass hohe Stückzahlen von 1000 pro Stunde auf einer Fertigungseinheit möglich sind.

Im Folgenden wird die Erfindung anhand mehrerer Ausführungsbeispielen näher erläutert. Es zeigen:
- Figur 1: Explosivdarstellung aller Bauelemente vor dem Zusammenbau
- Figur 2: Perspektivische Darstellung der erfindungsgemäßen Encoder-Elektromotor-Baueinheit im montierten Zustand
- Figur 3: Ausschnittsvergößerung im Bereich Leiterplatte/Zentrierbund

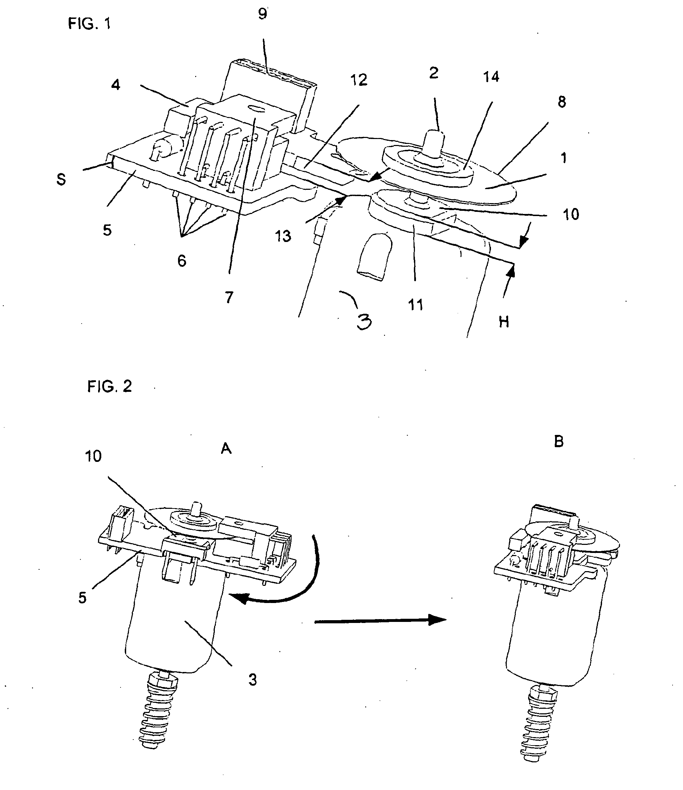

In Figur 1 ist eine erfindungsgemäße Encoder-Elektromotor-Baueinheit dargestellt, bestehend einerseits aus einer Taktscheibe 1, die auf einer Motorwelle 2 montierbar ist und zur Zentrierung eine Taktscheibennabe 14 aufweist, und andererseits einer Leiterplatte 5 mit Sensor-Emitter-Einheit 7 und einem Steckverbinder 9.

Die Motorwelle 2 ist Bestandteil eines Elektromotors 3. An der nach oben weisenden Seite des Motors 3 - der Flanschebene -, an der sich eine Durchtrittsöffnung für die Motorwelle 2 befindet, ist ein Zentrierbund 10 mit einer Abflachung 11 angeordnet. Die Form des Zentrierbundes 10 ist so ausgewählt, dass eine Zentrierung in der Flanschebene des Motors 3 in Bezug auf die Sensor-Emittter-Einheit 7 und die Taktscheibe 1 ermöglicht wird. Zum Einschieben in eine entsprechend ausgebildete Ausnehmung 12 weist die Leiterplatte 5 eine Zentrieröffnung 13 auf.

Die Leiterplatte 5 trägt alle für die elektrische Versorgung erforderlichen Anschlüsse 6, für die Sensor-Emitter-Einheit 7 und den Steckverbindern 9. Diese Elemente können durch einfaches Ineinanderstecken zu einer Baugruppe vormontiert und in einem Vorratsmagazin für die spätere Endmontage bereitgehalten werden.

Den fertigmontierten Zustand des neuen Encordersystems zeigt Figur 2. Um zu diesem Endzustand zu gelangen wird einfach die Taktscheibe 1 mit Taktscheibennabe 14 auf die Motorwelle 2 aufgesteckt und in Achsrichtung in die gewünschte Position vorgeschoben.
Diese Montage ist einfach und wird mit bekannten Werkzeugen bzw. Vorrichtungen bereits in hohen Stückzahlen ausgeführt.

Senkrecht zur Achsrichtung erfolgt die Montage der Leiterplatte 5 in einer als Flanschebene 15 bezeichneten und durch die Kreisfläche des im wesentlichen Kreisförmig ausgebildeten Zentrierbundes 10 reichenden Ebene, die mit der Stirnfläche des Elektromotors 3 parallel oder deckungsgleich verläuft. Die entsprechenden Montagebewegungen sind mit Pfeilen A, B in Figur 2 angedeutet.

Nach dem Abschluss der Vorschubbewegung in Pfeilrichtung B der Leiterplatte (5) erfolgt ein Drehen in der Flanschebene 15 um 90°. Hierdurch wird die Leiterplatte auf dem Zentrierbund 10 fixiert und gleichzeitig positioniert. Die Fixierung kann auf verschiedene Weise erfolgen, beispielsweise form- und/oder kraftschlüssig, durch Kleben, thermisches Verbinden, mechanisches Verbinden oder durch eine Kombination der genannten Verbindungsverfahren.

Zur Verdeutlichung des Montageverfahrens in der Flanschebene 15 wird auf Figur 3 Bezug genommen. In ihr ist ein Ausschnitt des Encodersystems im Bereich der Ausnehmung 12 der Leiterplatte 5 dargestellt, die über eine seitliche Öffnung 13 auf den Zentrierbund 10 aufsteckbar Ist. Hierzu ist die Einschubweite W zwischen der Abflachung 11 am Zentrierbund 10 und der gegenüberliegenden Kante enger ausgebildet als die seitliche Öffnung 13 der Leiterplatte 5.Wenn man beide Teile zusammenführt und dann den Zentrierbund 10 und die Leiterplatte 5 relativ zueinander um ca. 90°verdreht, erhält man eine formschlüssige Verbindung, die gleichzeitig für eine Fixierung und Positionierung der Elemente des Encodersystems nutzbar ist.

Im vorliegenden Fall hat die Ausnehmung 12 eine Omega-Form. Es sind aber auch andere Kombinationen zwischen Ausnehmung 12 und Zentrierbund 10 denkbar, beispielsweise herzförmige oder auch dreieckförmige Strukturen.

Ferner lässt sich die Fixierung durch verschiedene Maßnahmen erhöhen, beispielsweise durch Kombination von weichen und harten Werkstoffen. Hier entsteht nach dem Ineinanderstecken und Verdrehen eine kraftschlüssige Verbindung durch Verspannen gegeneinander oder Ineinanerverquetschen der Teile.

Ein weiteres Beispiel für eine formschlüssige Verbindung besteht darin, dass der Zentrierbund 10 am seitlich umlaufenden Rand zumindestens abschnittsweise eine Vertiefung aufweist, in die der Randabschluss der Ausnehmung 12 eingreift. Zur Intensivierung der Formschlüssigkeit wird vorzugsweise die Leiterplatte aus einem harten Material wie beispielsweise glasfaserverstärktem Kunststoff ausgebildet, wobei die Wanddicke dieses Materials geringfügig dünner sein sollte als die Wanddicke des Zentrierbundes 10 bzw. die darin eingeschnittene Nut.

In einer weiteren Ausgestaltung der Erfindung ist die Begrenzung der Ausnehmung 12 als Schneidkante ausgebildet, so dass die Leiterplatte 5 beim Einschieben und Verdrehen eine Vertiefung im Zentrierbund 10 hervorruft. Hierdurch wird in einfacher Weise eine feste und dauerhafte Fixierung zwischen Leiterplatte und Motor bewirkt.

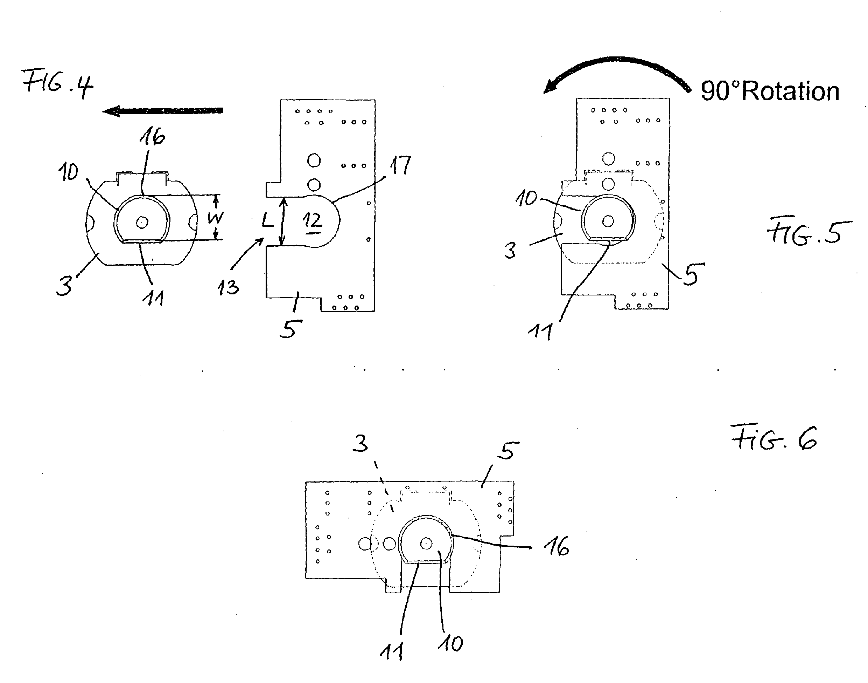

Fig.4 zeigt analog zu Fig. 1 die Situation vor dem Zusammenbau mit dem Motor 3, dem Zentrierbund 10 und der Abflachung 11, die zu einer reduzierten Einschubweite W führt.

Wenn die Leiterplatte 5 in Pfeilrichtung auf die Abflachung 11 geschoben wird, gelangt zunächst die seitliche Öffnung 13 der Ausnehmung 12 in Kontakt mit der umlaufenden Nut 16.

In Fig.5 ist die vollständig in die Flanschebene des Motors 3 eingeschobene Leiterplatte 5 dargestellt. Man erkennt, dass die lichte Weite "L" der Öffnung 13 größer ist als die Einschubweite "W" des Zentrierbundes 10.

Wenn der Zentrierbund 10 die Ausnehmung 12 nahezu vollständig ausfüllt, erfolgt eine Drehung um etwa 90°(siehe Pfeil-Rotation).

In Fig.6 ist die Nut 16 des Zentrierbundes 10 formschlüssig mit der Kante, z.B. einer Schneidkante 17 der Leiterplatte 5 verbunden.

## Patentansprüche

1. Encoder-Elektromotor-Baueinheit,
bestehend aus einer Taktscheibe (1), die auf eine Motorwelle (2) an der Flanschseite des Elektromotors (3) aufsteckbar ist, wobei der Elektromotor (3) an eine Energiequelle über Kontaktelemente (4) anschließbar ist,
einer Leiterplatte (5) mit Anschlüssen (6) für eine U-förmig ausgebildete Sensor-Emitter-Einheit (7), die den Randbereich (8) der Taktscheibe 1 umgreift und zum Empfang von Positionssignalen in dreidimensionaler Richtung justierbar ist,
einem Steckverbinder (9) mit Verbindungsleitern zur Herstellung von elektrisch leitenden Verbindungen zwischen den eine Baueinheit bildenden Elementen, die auf der Flanschseite des Elektromotor (3) mechanisch, thermisch und/oder durch Kleben befestigbar sind,
wobei
auf der der Taktscheibe (1) zugewandeten Flanschseite des Elektromotors (3) ein in Draufsicht annähernd kreisförmiger Zentrierbund (10) ausgebildet ist, wobei mindestens eine Seite des kreisförmigen Zentrierbundes (10) eine Abflachung (11) aufweist,
dass die Abflachung (11) zusammen mit der ihr gegenüberliegenden Kante des kreisförmigen Zentrierbundes (10) eine in Bezug auf den Durchmesser des kreisförmigen Zentrierbundes (10) reduzierte Einschubweite (W) bildet und dass die Leiterplatte (5) eine Ausnehmung (12) aufweist, in der der kreisförmige Zentrierbund formschlüssig und fixierbar durch Verdrehen gehalten wird, wobei in der Leiterplatte (5) - ausgehend von der Ausnehmung (12) eine seitliche Öffnung (13) vorhanden ist, deren lichte Weite (L) der reduzierten Einschubweite (W) des Zentrierbundes (10) entspricht.

2. Encoder-Elektromotor-Baueinheit nach Anspruch 1,
**dadurch gekennzeichnet, dass**
der Zentrierbund (10) eine in Achsrichtung der Motorwelle gemessene Seitenhöhe H aufweist, die größer ist als die Dicke S der Leiterplatte (5).

3. Encoder-Elektromotor-Baueinheit nach einem der vorhergehenden Ansprüche,
**dadurch gekennzeichnet, dass**
für die Leiterplatte (5) und den Zentrierbund (10) Werkstoffe mit unterschiedlicher Härte verwendet werden.

4. Encoder-Elektromotor-Baueinheit nach einem der vorhergehenden Ansprüche, **dadurch gekennzeichnet, dass**
als Werkstoff für die Leiterplatte (5) ein glasfaserverstärkter Kunststoff und als Werkstoff für den Zentrierbund (10) PVC, Polyuretan oder PE verwendet wird.

5. Encoder-Elektromotor-Baueinheit nach einem der vorhergehenden Ansprüche, **dadurch gekennzeichnet, dass**
in die, die Seitenhöhe H des Zentrierbundes (10) bildende Kante eine zumindest teilweise umlaufende Nut (16) eingeformt ist.

6. Encoder-Elektromotor-Baueinheit nach einem der vorhergehenden Ansprüche, **dadurch gekennzeichnet, dass**
das Einformen der Nut (16) über eine an der Leiterplatte (5) ausgebildete Schneidkante (17) erfolgt.

7. Encoder-Elektromotor-Baueinheit nach einem der vorhergehenden Ansprüche, **dadurch gekennzeichnet, dass**
die Fixierung zwischen Leiterplatte (5) und Zentrierbund (10) über eine Klemmmechanik, eine Klebe- oder Reibfläche oder durch eine Schweißnaht verstärkt wird.

8. Verfahren zur Montage einer Encoder-Elektromotor-Baueinheit,
wobei folgende Elemente zu einer Baugruppe verbunden werden
eine Taktscheibe (1), die auf einer Motorwelle (2) an der Flanschseite eines Elektromotors (3) aufsteckbar ist, wobei der Elektromotor (3) an einer Energiequelle über Kontaktelementen (4) anschließbar ist,
einer Leiterplatte (5) mit Anschlüssen (6) für eine U-förmig ausgebildete Sensor-Emitter-Einheit (7), die den Randbereich (8) der Taktscheibe 1 umgreift und zum Empfang von Positionssignalen in dreidimensionaler Richtung justierbar ist,
einem Steckverbinder (9) mit Verbindungsleitern zur Herstellung von elektrisch leitenden Verbindungen zwischen den eine Baueinheit bildenden Elementen, die auf der Flanschseite des Elektromotors (3) mechanisch, thermisch und/oder durch Kleben befestigt sind,
**dadurch gekennzeichnet, dass**
zuerst die Taktscheibe (1) auf die Motorwelle (2) des Elektromotors (3) aufgesteckt wird, der einen Zentrierbund (10) mit mindestens einer Abflachung (11) aufweist, wobei die Abflachung (11) zusammen mit der ihr gegenüberliegenden Kante des kreisförmigen Zentrierbundes (10) eine in Bezug auf den Durchmesser des kreisförmigen Zentrierbundes (10) reduzierte Einschubweite (W) aufweist, was eine Schmalseite des Zentrierbunds darstellt
und dann die mit den eine Baugruppe bildenden Elementen vormontierte Leiterplatte (5), die eine zum Rand hin offene Ausnehmung aufweist, wobei in der Leiterplatte (5) ausgehend von der Ausnehmung (12) eine seitliche Öffnung (13) vorhanden ist, deren lichte Weite (L) der reduzierten Einschubweite (W) des Zentrierbundes (10) entspricht, seitlich in die Flanschebene des Elektromotors (3) über die Schmalseite des Zentrierbundes (10) in eine Justierstellung gebracht und durch Verdrehen fixiert wird, wobei der kreisförmige Zentrierbund formschlüssig gehalten wird.

9. Verfahren nach Anspruch 8, **dadurch gekennzeichnet, dass** die Drehbewegung um 90° erfolgt.

10. Verfahren nach den Ansprüchen 8 oder 9, **dadurch gekennzeichnet, dass** vor dem Ineinanderstecken von Leiterplatte und Zentrierbund (10) in die offene Ausnehmung (12) ein Kleben angebracht und dieser nach dem Ineinanderstecken und Verdrehen zur Aushärtung gebracht wird.

## Claims

1. An encoder-electric motor unit consisting of
an encoder disc (1) which can be mounted on a motor shaft (2) at the flange end of the electric motor (3), wherein the electric motor (3) can be connected to an energy source via contact elements (4);
a conductor plate (5) with connections (6) for a U-shaped sensor-emitter unit (7) which embraces the edge region (8) of the encoder disc (1) and which can be adjusted in a three-dimensional direction to receive positional signals;
a plug-in connector (9) with connecting conductors for providing electrically conducting connections between the elements which form a unit and which can be secured at the flange end of the electric motor (3) mechanically, thermally and/or by gluing,
wherein
a centring collar (10) which is approximately circular in a plan view is provided at the flange end of the electric motor (3), which flange end faces the encoder disc (1), wherein at least one side of the circular centring collar (10) comprises a flattened portion (11),
wherein the flattened portion (11), together with the opposed edge of the circular centring collar (10), forms an insertion width (W) which is reduced relative to the diameter of the circular centring collar (10); and
wherein the conductor plate (5) comprises a recess (12) in which the circular centring collar is held in a form-fitting way and is fixable by being rotated,
wherein in the conductor plate (5) there is provided a lateral aperture (13) which starts from the recess (12) and whose clear width (L) corresponds to the reduced insertion width (W) of the centring collar (10).

2. An encoder-electric motor unit according to claim 1,
**characterised in**
**that** the centring collar (10) comprises a lateral height H which is measured in the axial direction of the motor shaft and which is greater than the thickness S of the conductor plate (5).

3. An encode-electric motor unit according to any one of the preceding claims,
**characterised in**
**that** materials with different hardness values are used for the conductor plate (5) and the centring collar (10).

4. An encoder-electric motor unit according to any one of the preceding claims,
**characterised in**
**that** the conductor plate (5) is produced from glass-fibre-reinforced plastics and the centring collar (10) from PVC, polyurethane or PE.

5. An encodar-electric motor unit according to any one of the preceding claims,
**characterised in**
**that** an at least partially continuous groove (16) is formed into the edge forming the lateral height H of the centring collar (10).

6. An encoder-electric-motor unit according to any one of the preceding claims,
**characterised in**
**that** the groove (16) is formed via a cutting edge (17) provided at the conductor plate (5).

7. An encoder-electric motor unit according to any one of the preceding claims,
**characterised in**
**that** the fixing between the conductor plate (5) and the centring collar (10) is reinforced by a clamping method, a glued face or friction face or by a weld.

8. A method of mounting an encoder-electric motor unit,
wherein the following elements arc connected to form a unit:
an encoder disc (1) which can be mounted on a motor shaft (2) at the flange end of the electric motor (3), wherein the electric motor (3) can be connected to an energy source via contact elements (4);
a conductor plate (5) with connections (6) for a U-shaped sensor-emitter unit (7) which embraces the edge region (8) of the encoder disc (1) and which can be adjusted in a three-dimensional direction to receive positional signals;
a plug-in connector (9) with connecting conductors for providing electrically conducting connections between the elements which form a unit and which can be secured at the flange end of the electric motor (3) mechanically, thermally and/or by gluing,
**characterised in**
**that** first the encoder disc (1) is mounted on the motor shaft (2) of the electric motor (3) which comprises a centring collar (10) with at least one flattened portion (11), wherein the flattened portion (11), together with the opposed edge of the circular centring collar (10), comprises an insertion width (W) which is reduced relative to the diameter of the circular centring collar (10), which constitutes a narrow side of the centring collar,
and then the conductor plate (5) which is pre-assembled with the elements forming a unit and which comprises a recess which opens towards the edge,
wherein the conductor plate is provided with a lateral aperture (13) which starts from the recess (12) and whose clear width corresponds to the reduced insertion width (W) of the centring collar (10), is introduced laterally into the flange plane of the electric motor (3) via the narrow side of the centring collar (10) into an adjustable position and fixed by being rotated, wherein the circular centring collar is held in a form-fitting way.

9. A method according to claim 8,
**characterised in**
**that** the rotational movement covers 90°.

10. A method according to claim 8 or 9,
**characterised in**
**that** before the conductor plate and the centring collar (10) are inserted into one another in the open recess (12), there is applied a glue which is hardened following the insertion and rotation processes.

## Revendications

1. Unité comprenant un codeur et un moteur électrique, composée:
d'un disque de codage (1) qui pourra être emboîté sur l'arbre du moteur (2) du coté bride d'un moteur électrique (3), en tenant compte que le moteur électrique (3) pourra être connecté à une alimentation en courant par éléments de contacts (4);
d'une plaquette de circuits imprimés (5) à raccordements (6) pour un bloc détecteur-émetteur (7) en forme de U, entourant la surface marginale (8) du disque de codage (1), et ajustable dans trois dimensions, afin de détecter les signaux de positionnement;
d'un connecteur à fiches (9) avec conducteurs pour établir des connexions électriques entre les éléments formant une unité qui pourront être montés mécaniquement, thermiquement et/ou par collage sur le coté bride du moteur (3);
en tenant compte qu' un collet de centrage approximativement circulaire (10) est formé, vu d'en haut, sur le coté bride du moteur électrique (3), face au disque de codage (1) et que le collet de centrage circulaire (10) présente un aplatissement (11) sur un coté au moins;
que l'aplatissement (11) présente avec le bord du collet de centrage circulaire (10) lui faisant face, une largeur d'insertion (W) réduite par rapport au diamètre du collet de centrage circulaire (10) et que la plaquette de circuits imprimés (5) présente une découpure (12) qui permet d'assurer le serrage adéquat du collet de centrage circulaire et de le fixer par rotation, compte tenu du fait qu'une ouverture latérale (13) est découpée sur la plaquette de circuits imprimés (5) partant de la découpure (12), et dont la largeur intérieure (L) correspond à la largeur d'insertion réduite (W) du collet de centrage.

2. Unité comprenant un codeur et un moteur électrique conformément à la revendication 1,
**caractérisée par le fait que**
le collet de centrage (10) présente une hauteur latérale H, mesurée dans la direction axiale de l'arbre du moteur, étant supérieure à l'épaisseur S de la plaquette de circuits imprimés (5).

3. Unité comprenant un codeur et un moteur électrique conformément à l'une des revendications sus-mentionnées, **caractérisée par le fait que**
des matériaux ayant différents degrés de dureté ont été utilisés pour la plaquette de circuits imprimés (5) comme pour le collet de centrage (10).

4. Unité comprenant un codeur et un moteur électrique conformément à l'une des revendications sus-mentionnées, **caractérisée par le fait qu'**
une matière synthétique armée aux fibres de verre est utilisée comme matériau pour la plaquette de circuits imprimés (5), et que le polychlorure de vinyle, ou le polyuréthane ou encore le polyéthylène soient utilisés comme matériau pour le collet de centrage (10).

5. Unité comprenant un codeur et un moteur électrique conformément l'une des revendications sus-mentionnées, **caractérisée par le fait que**
le bord formé par la hauteur H du collet de centrage (10) présente une rainure circulaire (16) du moins en partie.

6. Unité comprenant un codeur et un moteur électrique conformément à l'une des revendications sus-mentionnées, **caractérisée par le fait que**
l'entaille de la rainure (16) est réalisée par une arête tranchante (17) prévue sur la plaquette de circuits imprimés (5).

7. Unité comprenant un codeur et un moteur électrique conformément à l'une des revendications sus-mentionnées, **caractérisée par le fait que**
la fixation entre la plaquette de circuits imprimés (5) et le collet de centrage (10) est renforcée par un système mécanique de serrage, ou par une surface collante ou par une surface de friction, ou encore par soudure.

8. Procédé de montage d'une unité comprenant un codeur et un moteur électrique, les éléments suivants formant une unité:
un disque de codage (1) qui pourra être emboîté sur l'arbre du moteur (2) du coté bride d'un moteur électrique (3), en tenant compte que le moteur électrique (3) pourra être connecté à une alimentation en courant par éléments de contacts (4);
une plaquette de circuits imprimés (5) à raccordements (6) pour un bloc détecteur-émetteur (7) en forme de U, entourant la surface marginale (8) du disque de codage (1), et ajustable dans trois dimensions, afin de détecter les signaux de positionnement;
un connecteur à fiches (9) avec conducteurs pour établir des connexions électriques entre les éléments formant une unité qui pourront être montés mécaniquement, thermiquement et/ou par collage sur le coté bride du moteur (3);
en tenant compte
qu'un collet de centrage approximativement circulaire (10) est formé, vu d'en haut, sur le coté bride du moteur électrique (3), face au disque de codage (1) et que le collet de centrage circulaire (10) présente un aplatissement (11) sur un coté au moins;
**caractérisé par le fait que**
le disque de codage (1) sera emboîté en premier sur l'arbre du moteur (2) du moteur électrique (3), présentant un collet de centrage (10) avec un aplatissement (11) au moins, en tenant compte du fait que l'aplatissement (11) présente, avec le bord du collet de centrage circulaire (10) lui faisant face, une largeur d'insertion (W) réduite par rapport au diamètre du collet de centrage circulaire (10), ce qui représente un coté étroit du collet de centrage;
puis, que la plaquette de circuits imprimés (5) avec les éléments formant une unité, montés au préalable, présentant une découpure ouverte jusqu'au bord, la plaquette de circuits imprimés (5) ayant une ouverture latérale (13) partant de la découpure (12), dont la largeur intérieure (L) correspond à la largeur d'insertion réduite (W) du collet de centrage (10), est placée dans une position d'ajustage, latéralement au niveau de la bride du moteur électrique (3), par le coté étroit du collet de centrage (10) et qu'elle est fixée par rotation, le serrage adéquat du collet de centrage circulaire étant assuré.

9. Procédé de montage conformément à la revendication 8, **caractérisé par le fait qu'**une rotation de 90° est effectuée.

10. Procédé de montage conformément aux revendications 8 et 9, **caractérisé par le fait qu'**une colle est appliquée dans la découpure ouverte (12), avant l'emboîtement de la plaquette de circuits imprimés (5) avec le collet de centrage (10), et qu'elle sera durcie après l'emboîtement et la rotation.
